# EUROPEAN PATENT APPLICATION

(11) **EP 4 756 522 A1**
(43) Date of publication of application: **10.06.2026**
(21) Application number: 24847685.5
(22) Date of filing: 06.05.2024
(51) Int. Cl.: G02F 1/13357, F21V 23/00, F21V 19/00

(54) **LIGHT-EMITTING PLATE AND PREPARATION METHOD THEREFOR, BACKLIGHT MODULE AND DISPLAY APPARATUS**

(30) Priority: 03.08.2023 CN 202310978268
(71) Applicant: Huizhou Vision New Technology Co., Ltd., Huizhou, Guangdong 516000 (CN)
(72) Inventor: YANG, Hao, Guangdong 516000 (CN); LI, Jianlin, Guangdong 516000 (CN); WANG, Daiqing, Guangdong 516000 (CN)
(74) Representative: Herrero & Asociados, S.L.
(86) International application number: PCT/CN2024/091282
(87) International publication number: WO 2025/025719

(57) **Abstract**

A light-emitting plate (10) and a preparation method therefor, a backlight module and a display apparatus. The light-emitting plate (10) comprises: a circuit board (11), comprising a substrate layer (111) and a circuit layer (112), wherein the circuit layer (112) is attached to one side surface of the substrate layer (111), the other side surface of the substrate layer (111) is a light-emitting surface (13), and through holes (113) are formed in the circuit board (11); and light-emitting devices (12), each comprising a fixed part (21) and an LED light-emitting unit (122), wherein the LED light-emitting unit (122) is fixed on the fixed part (21), the light-emitting devices (12) are arranged corresponding to the through holes (113), the fixed parts (21) are arranged on one side of the circuit layer (112), and the LED light-emitting units (122) face the light-emitting surface (13) by means of the through holes (113).

## Description

This present application claims priority of the Chinese patent application with the Chinese Patent Application No. 202310978268.1, filed in the China National Intellectual Property Administration on August 3, 2023, and entitled "LIGHT-EMITTING PLATE AND PREPARATION METHOD THEREFOR, BACKLIGHT MODULE, AND DISPLAY APPARATUS", which is incorporated herein by reference in its entirety.

### TECHNICAL FIELD

The present application relates to the field of display technologies, and in particular, to a light-emitting plate and preparation method therefor, a backlight module, and a display apparatus.

### BACKGROUND

As display apparatus become thinner and lighter, the light-mixing distance of light-emitting devices decreases, which imposes increasingly stringent requirements on the reflection conditions of the light-emitting plate. In the preparing process of existing light-emitting plates, the light-emitting devices and other components are all disposed on the same side of the substrate. The component may interfere with the light-emitting path of the light-emitting devices, affecting the light-mixing effect and brightness uniformity of the light-emitting plate. Moreover, as local dimming becomes more precise, component such as IC, resistor, and capacitor on the light-emitting plate become more densely packed, the affecting becomes more pronounced.

### TECHNICAL PROBLEMS

Existing solutions involve applying a high-reflectivity white adhesive on the component or covering the component with reflective paper. However, these methods maynot completely eliminate the impact of the component on the light-mixing effect. Furthermore, the methods of applying white adhesive and attaching reflective paper are cumbersome, which adversely affects production efficiency and cost.

### TECHNICAL SOLUTIONS

In a first aspect, an embodiment of the present application provides a light-emitting plate, including:
a circuit board, wherein the circuit board includes a substrate layer and a circuit layer, the circuit layer is attached to one side surface of the substrate layer, another side surface of the substrate layer is a light-emitting surface, and a through hole is formed in the circuit board; and
a light-emitting device, wherein the light-emitting device includes a fixing portion and an LED (light-emitting diode) light-emitting unit, the LED light-emitting unit is fixed on the fixing portion, the light-emitting device is disposed corresponding to the through hole, the fixing portion is disposed on a side of the circuit layer, and the LED light-emitting unit faces the light-emitting surface through the through hole.

In a second aspect, an embodiment of the present application further provides a method for preparing a light-emitting plate, including:
providing a circuit board, wherein the circuit board includes a substrate layer and a circuit layer, the circuit layer is attached to one side surface of the substrate layer, another side surface of the substrate layer is a light-emitting surface, and a through hole is formed in the circuit board;
providing a light-emitting device, wherein the light-emitting device includes a fixing portion and an LED light-emitting unit, and the LED light-emitting unit is fixed on the fixing portion;
disposing the light-emitting device corresponding to the through hole; and
fixing the fixing portion on a side of the circuit layer, such that the LED light-emitting unit faces the light-emitting surface through the through hole.

In a third aspect, an embodiment of the present application further provides a backlight module including a light-emitting plate, wherein the light-emitting plate includes:
a circuit board, wherein the circuit board includes a substrate layer and a circuit layer, the circuit layer is attached to one side surface of the substrate layer, another side surface of the substrate layer is a light-emitting surface, and a through hole is formed in the circuit board; and
a light-emitting device, wherein the light-emitting device includes a fixing portion and an LED light-emitting unit, the LED light-emitting unit is fixed on the fixing portion, the light-emitting device is disposed corresponding to the through hole, the fixing portion is disposed on a side of the circuit layer, and the LED light-emitting unit faces the light-emitting surface through the through hole.

In a fourth aspect, an embodiment of the present application further provides a backlight module including a light-emitting plate prepared by a method for preparing a light-emitting plate, wherein the method for preparing the light-emitting plate includes:
providing a circuit board, wherein the circuit board includes a substrate layer and a circuit layer, the circuit layer is attached to one side surface of the substrate layer, another side surface of the substrate layer is a light-emitting surface, and a through hole is formed in the circuit board;
providing a light-emitting device, wherein the light-emitting device includes a fixing portion and an LED light-emitting unit, and the LED light-emitting unit is fixed on the fixing portion;
disposing the light-emitting device corresponding to the through hole; and
fixing the fixing portion on a side of the circuit layer, such that the LED light-emitting unit faces the light-emitting surface through the through hole.

In a fifth aspect, an embodiment of the present application further provides a display apparatus including a backlight module; wherein the backlight module includes a light-emitting plate, and the light-emitting plate includes:
a circuit board, wherein the circuit board includes a substrate layer and a circuit layer, the circuit layer is attached to one side surface of the substrate layer, another side surface of the substrate layer is a light-emitting surface, and a through hole is formed in the circuit board; and
a light-emitting device, wherein the light-emitting device includes a fixing portion and an LED light-emitting unit, the LED light-emitting unit is fixed on the fixing portion, the light-emitting device is disposed corresponding to the through hole, the fixing portion is disposed on a side of the circuit layer, and the LED light-emitting unit faces the light-emitting surface through the through hole.

### BENEFICIAL EFFECTS

In the light-emitting plate and preparation method therefor, the backlight module, and the display apparatus provided by the embodiments of the present application, the light-emitting plate includes a circuit board and a light-emitting device. Specifically, the circuit board includes a substrate layer and a circuit layer. The circuit layer is attached to one side surface of the substrate layer, and another side surface of the substrate layer is a light-emitting surface. A through hole is formed in the circuit board. The light-emitting device includes a fixing portion and an LED light-emitting unit. The light-emitting device is disposed corresponding to the through hole. The fixing portion is disposed on a side of the circuit layer, and the LED light-emitting unit faces the light-emitting surface through the through hole. It should be understood that the light-emitting surface and the component of the light-emitting plate are disposed on opposite sides of the substrate layer of the circuit board, so that the impact of the component on the light-mixing effect is completely eliminated, and there is no need to apply white glue and attach reflective paper on the component, thereby improving the luminous uniformity of the light-emitting plate.

### BRIEF DESCRIPTION OF DRAWINGS

FIG. 1 is a schematic diagram of a first structural of a light-emitting plate according to an embodiment of the present application.
FIG. 2 is a schematic diagram of a second structural of a light-emitting plate according to an embodiment of the present application.
FIG. 3 is a schematic diagram of a first structural of a circuit board according to an embodiment of the present application.
FIG. 4 is a schematic diagram of a first structural of a light-emitting device according to an embodiment of the present application.
FIG. 5 is a schematic diagram of a second structural of a light-emitting device according to an embodiment of the present application.
FIG. 6 is a schematic diagram of a second structural of a circuit board according to an embodiment of the present application.
FIG. 7 is a schematic diagram of a third structural of a light-emitting device according to an embodiment of the present application.
FIG. 8 is a schematic flowchart of a first method for preparing a light-emitting plate according to an embodiment of the present application.
FIG. 9 is a schematic diagram of a first process for a light-emitting plate according to an embodiment of the present application.
FIG. 10 is a schematic flowchart of a second method for preparing a light-emitting plate according to an embodiment of the present application.
FIG. 11 is a schematic flowchart of a third method for preparing a light-emitting plate according to an embodiment of the present application.
FIG. 12 is a schematic flowchart of a fourth method for preparing a light-emitting plate according to an embodiment of the present application.
FIG. 13 is a schematic diagram of second process for a light-emitting plate according to an embodiment of the present application.
FIG. 14 is a schematic flowchart of a fifth method for preparing a light-emitting plate according to an embodiment of the present application.

### EMBODIMENTS OF THE PRESENT APPLICATION

The technical solutions in the embodiments of the present application will be clearly and completely described below with reference to the accompanying drawings in the embodiments of the present application. Apparently, the described embodiments are merely some rather than all of the embodiments of the present application. Based on the embodiments in the present application, all other embodiments obtained by those skilled in the art without creative efforts shall fall within the protection scope of the present application.

As display apparatus become thinner and lighter, the light-mixing distance of light-emitting devices decreases, which imposes increasingly stringent requirements on the reflection conditions of the light-emitting plate. In the preparing process of existing light-emitting plates, the light-emitting devices and other components are all disposed on the same side of the substrate. The components may interfere with the light-emitting path of the light-emitting devices, affecting the light-mixing effect and brightness uniformity of the light-emitting plate. Moreover, as local dimming becomes more precise, component such as IC, resistor, and capacitor on the light-emitting plate become more densely packed, and this impact becomes more pronounced. Existing solutions involve applying a high-reflectivity white adhesive on the component or covering the component with reflective paper. However, these methods maynot completely eliminate the impact of the component on the light-mixing effect. Furthermore, the methods of applying white adhesive and attaching reflective paper are cumbersome, which adversely affects production efficiency and cost.

In the method for preparing a light-emitting plate in the related art, LED and other components are welded on the same side of the light-emitting plate. The protrusions of the components impair the overall reflection effect of the light-emitting plate, and as the light-mixing distance decreases, this impact becomes more pronounced. The solution in the related art is to cover other components by applying white adhesive or attaching reflective paper. However, this still maynot completely eliminate the impact of the components on the light-mixing effect, and the methods of applying white adhesive and attaching reflective paper are cumbersome, which adversely affects production efficiency and cost.

Accordingly, the present application provides a light-emitting plate and preparation method therefor, a backlight module, and a display apparatus, which will be described in detail below with reference to the accompanying drawings.

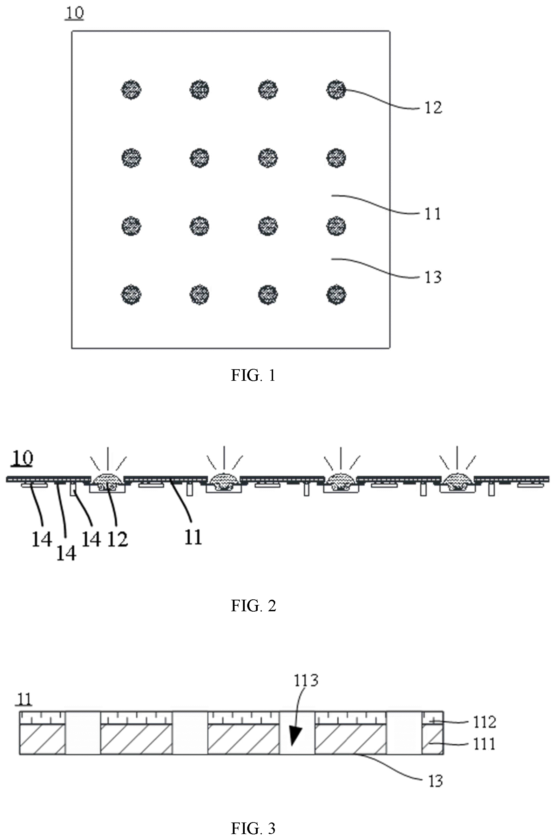

Referring to FIG. 1 and FIG. 2, FIG. 1 is a schematic diagram of a first structural of a light-emitting plate according to an embodiment of the present application, and FIG. 2 is a schematic diagram of a second structural of a light-emitting plate according to an embodiment of the present application. An embodiment of the present application provides a light-emitting plate 10, which includes a circuit board 11 and a light-emitting device 12.

Referring to FIG. 3, FIG. 3 is a schematic diagram of a first structural of a circuit board according to an embodiment of the present application. The circuit board 11 has a multilayer structure. The circuit board 11 includes a substrate layer 111 and a circuit layer 112, and the circuit layer 112 is attached to the substrate layer 111. The circuit layer 112 is attached to one side surface of the substrate layer 111, and another side surface of the substrate layer 111 is a light-emitting surface 13. A through hole 113 is formed in the circuit board 11, and the through hole 113 penetrates the substrate layer 111 and the circuit layer 112. The circuit layer 112 is configured to fix a component 14, that is, the component 14 is fixed on the circuit layer 112. The component 14 may be a resistor, a capacitor, an IC (Integrated Circuit), or a jumper wire. The material of the circuit layer 112 may be copper. The circuit layer 112 may be formed by a process including: covering the substrate layer 111 with a copper layer, and then etching the copper layer to form the circuit layer 112. The circuit layer 112 may supply power or provide electrical signals to the component 14 electrically connected thereto.

The substrate layer 111 may be an aluminum substrate, an FR4 substrate, or a BT substrate.

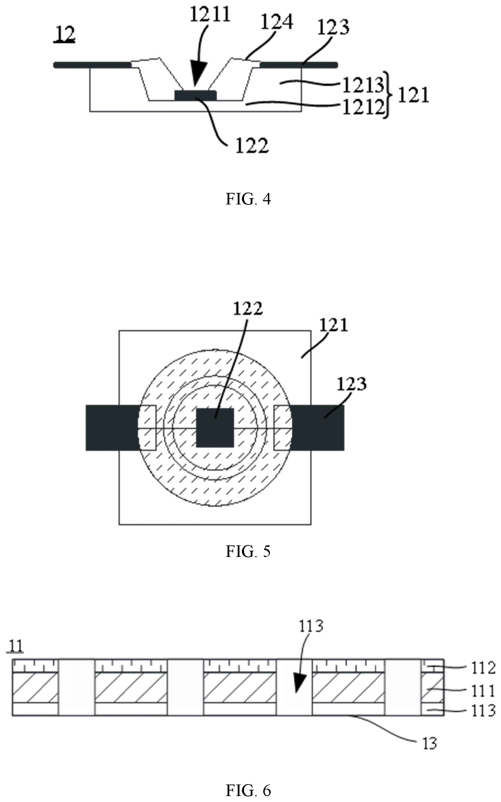

Referring to FIG. 4 and FIG. 5, FIG. 4 is a schematic diagram of a first structural of a light-emitting device according to an embodiment of the present application, and FIG. 5 is a schematic diagram of a second structural of a light-emitting device according to an embodiment of the present application. The light-emitting device 12 includes a fixing portion 21 and an LED light-emitting unit 122. The LED light-emitting unit 122 is fixed on the fixing portion 21. The light-emitting device 12 is disposed corresponding to the through hole 113. The fixing portion 21 is disposed on a side of the circuit layer 112, and the LED light-emitting unit 122 faces the light-emitting surface 13 through the through hole 113.

The fixing portion 21 is fixed on a side of the circuit layer 112 away from the substrate layer 111, and the LED light-emitting unit 122 is located on a side of the fixing portion 21 adjacent to the circuit layer 112. The LED light-emitting unit 122 is electrically connected to the circuit layer 112, and a power source supplies power to the LED light-emitting unit 122 through the circuit layer 112. Light generated by the LED light-emitting unit 122 passes through the through hole 113 and is emitted from the side of the substrate layer 111 away from the circuit layer 112, such that the side surface of the substrate layer 111 away from the circuit layer 112 forms the light-emitting surface 13. The fixing portion 21 may be a structure for supporting or fixing the LED light-emitting unit 122, such as a lamp bracket, a lamp support, or a lamp holder.

The LED light-emitting unit 122 may be a light-emitting diode (LED), a mini light-emitting diode (mini-LED), or a micro light-emitting diode (micro-LED).

The component 14 is disposed on the side of the circuit layer 112 away from the substrate layer 111. The component 14 may be spaced apart from the light-emitting device 12. Furthermore, on the circuit layer 112, the component 14 may be spaced apart from the fixing portion 21 to prevent mutual interference between charged bodies or even short circuits.

It should be understood that the light-emitting surface 13 and the component 14 of the light-emitting plate 10 are formed on opposite sides of the substrate layer 111 of the circuit board 11, so that the impact of the component 14 on the light-mixing effect is completely eliminated, and there is no need to apply white glue and attach reflective paper on the component 14, thereby improving the luminous uniformity of the light-emitting plate.

Referring to FIG. 6, FIG. 6 is a schematic diagram of a second structural of a circuit board according to an embodiment of the present application. To improve the light reflectivity of the circuit board 11, the circuit board 11 further includes a white ink layer 114. The white ink layer 114 is disposed on the side of the substrate layer 111 away from the circuit layer 112. Thus, the circuit board 11 includes the circuit layer 112, the substrate layer 111, and the white ink layer 114 stacked in sequence. As described above, the through hole 113 is formed in the circuit board 11, and the through hole 113 sequentially penetrates the circuit layer 112, the substrate layer 111, and the white ink layer 114. When light generated by the LED light-emitting unit 122 passes through the through hole 113 and is emitted from the side of the substrate layer 111 away from the circuit layer 112, a side surface of the white ink layer 114 away from the circuit layer 112 forms the light-emitting surface 13, thereby light emitted to the white ink layer 114 may be reflected and re-emitted to avoid being absorbed by the substrate layer 111, which is beneficial to increase the light intensity of the light-emitting surface.

In some embodiments, referring to FIG. 4 and FIG. 5, the fixing portion 21 defines a cup opening 1211, and the LED light-emitting unit 122 is disposed in the cup opening 1211, and may be disposed at the center of the cup opening 1211. It should be understood that the fixing portion 21 may be a base on which a recess is formed, and the recess serves as the cup opening 1211. In this case, the LED light-emitting unit 122 being disposed at the center of the cup opening 1211 means that the LED light-emitting unit is disposed at the center of the base, and at the deepest point of the recess. The cup opening 1211 is in communication with the through hole 113. That is, the fixing portion 21 includes a base seat 1212 and a sidewall 1213. The sidewall 1213 is connected to the base seat 1212, and the sidewall 1213 and the base seat 1212 enclose to form the cup opening 1211.

The light-emitting device 12 further includes a pad 123. The pad 123 is disposed on the fixing portion 21. The pad 123 may be disposed on an end of the sidewall 1213 of the fixing portion 21 away from the base seat 1212. The fixing portion 21 is soldered and fixed to the circuit layer 112 by the pad 123, that is, the pad 123 connects the circuit layer 112 and the fixing portion 21 respectively. Since the material of the pad 123 is metal, when the pad 123 is connected to the circuit layer 112, the pad 123 further functions as a conductor. The LED light-emitting unit 122 is also electrically connected to the pad 123, so that the LED light-emitting unit 122 is indirectly electrically connected to the circuit layer 112, thereby reducing the need for jumper wire, saving cost, and saving space.

Therefore, in the embodiments of the present application, the pad 123 is connected between the fixing portion 21 and the circuit layer 112, and the pad 123 is also electrically connected to the LED light-emitting unit 122. The pad 123 may not only fix the fixing portion 21 on the circuit layer 112, but also utilize its conductivity to transmit electrical signals from the circuit layer 112 to the LED light-emitting unit 122, such that the LED light-emitting unit 122 may be turned on or turned off.

The light-emitting device 12 further includes a gold wire 124. The gold wire 124 is electrically connected to the LED light-emitting unit 122 and the pad 123. The gold wire 124 has excellent electrical conductivity and is configured to transmit electrical signals to the LED light-emitting unit 122. It may be understood that since the cup opening 1211 is provided to accommodate the LED light-emitting unit 122, the gold wire 124 may be accommodated in the cup opening 1211, such that the gold wire 124 does not occupy additional space. The LED light-emitting unit 122 has a positive electrode and a negative electrode. Correspondingly, there are also two gold wires 124 and two pads 123, which are denoted as a first gold wire 124, a second gold wire 124, a first pad 123, and a second pad 123, respectively. The first pad 123 and the second pad 123 are spaced apart on the fixing portion 21. One end of the first gold wire 124 is electrically connected to the first pad 123, and another end thereof is electrically connected to the positive electrode of the LED light-emitting unit 122. The first pad 123 is electrically connected to the circuit layer 112. One end of the second gold wire 124 is electrically connected to the second pad 123, and another end thereof is electrically connected to the negative electrode of the LED light-emitting unit 122. The second pad 123 is electrically connected to the circuit layer 112.

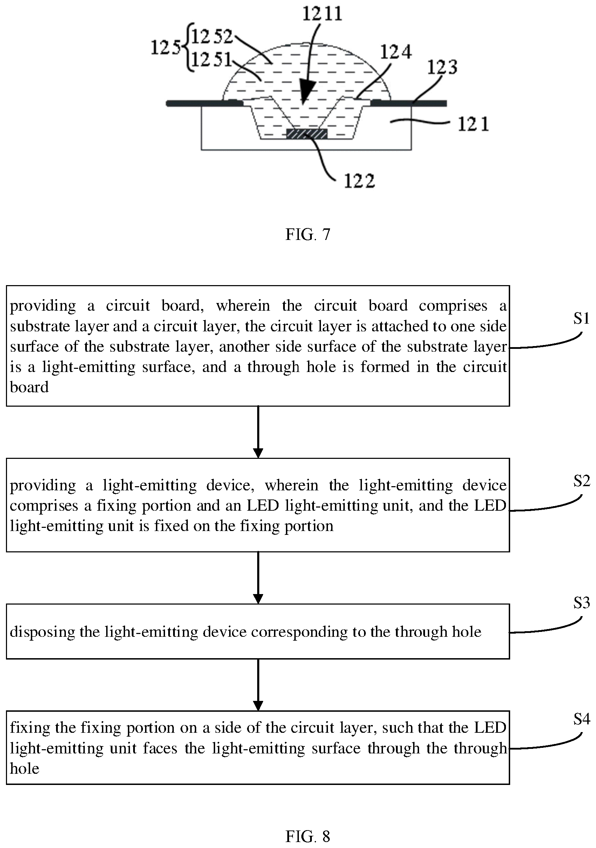

In some embodiments, referring to FIG. 7, FIG. 7 is a schematic diagram of a third structure of a light-emitting device according to an embodiment of the present application. The light-emitting device 12 further includes a lens 125. The lens 125 covers the LED light-emitting unit 122. The lens 125 is configured to expand a light-emitting angle of the LED light-emitting unit 122.

In some cases, continuing to refer to FIG. 7, the LED light-emitting unit 122 is a blue light-emitting unit configured to emit blue light. A material of the lens 125 includes a resin polymer 1251 and a white phosphor powder 1252. The white phosphor powder 1252 is dispersed in the resin polymer 1251. The white phosphor powder 1252 is configured to convert the blue light emitted by the LED light-emitting unit 122 into white light. In other cases, the LED light-emitting unit 122 is a blue light-emitting unit configured to emit blue light. The material of the lens 125 includes a resin polymer 1251 and a yellow phosphor powder. The yellow phosphor powder is dispersed in the resin polymer 1251. The yellow phosphor powder is configured to convert a portion of the blue light emitted by the LED light-emitting unit 122 into yellow light, and the yellow light and the remaining blue light combine to form white light. In still other cases, the LED light-emitting unit 122 is an ultraviolet light-emitting unit configured to emit ultraviolet light. The material of the lens 125 includes a resin polymer 1251, a red phosphor powder, a green phosphor powder, and a blue phosphor powder. The red phosphor powder, the green phosphor powder, and the blue phosphor powder are dispersed in the resin polymer 1251. The red phosphor powder, the green phosphor powder, and the blue phosphor powder are excited by ultraviolet light to form red light, green light, and blue light respectively, and the red light, the green light, and the blue light combine to form white light.

The resin polymer 1251 is a thermosetting resin or a photocurable resin. When the resin polymer 1251 is a photocurable resin, the resin polymer 1251 may be cured by ultraviolet light irradiation. When the resin polymer 1251 is a thermosetting resin, the resin polymer 1251 may be cured by heating. The thermosetting resin and the photocurable resin each have their advantages. During the use of thermosetting resin, the thermosetting resin have excellent heat resistance, which may prevent the resin polymer 1251 from deforming due to heat generated by the LED light-emitting unit 122. In the curing process, the photocurable resin have a lower process temperature, which makes it less likely for the LED light-emitting unit 122 and the fixing portion 21 to be damaged by heat.

A composition of the material of the lens 125 by mass percentage, includes: 80%-90% of the resin polymer 1251 and 10%-20% of the phosphor powder. The phosphor powder may be the total of the phosphor powders in the various cases. That is, in some cases, the phosphor powder may be only the white phosphor powder 1252; in other cases, the phosphor powder may be only the yellow phosphor powder; and in still other cases, the phosphor powder may also include the red phosphor powder, the green phosphor powder, and the blue phosphor powder. When the proportion of components in the material of the lens 125 is within the above-mentioned range, the phosphor powder may be uniformly mixed in the resin polymer 1251, and provides good light transmittance and an effective light excitation effect.

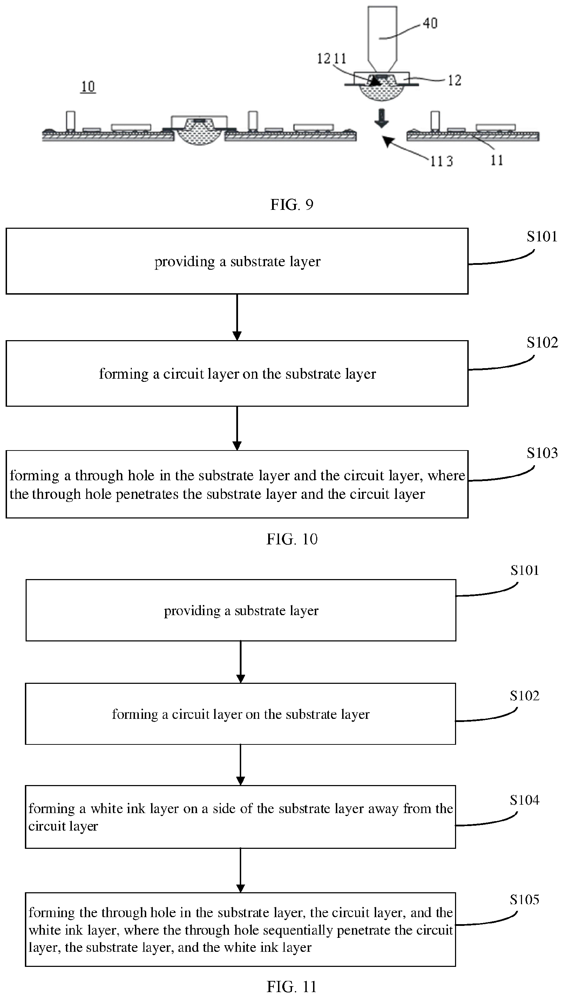

Referring to FIG. 8 and FIG. 9, FIG. 8 is a schematic flowchart of a first method for preparing a light-emitting plate according to an embodiment of the present application. FIG. 9 is a schematic diagram of a first process for a light-emitting plate according to an embodiment of the present application.

An embodiment of the present application further provides a method for preparing a light-emitting plate 10. The method for preparing the light-emitting plate 10 includes the following steps. It should be noted that the method steps provided in the present application are not limited to the steps provided in this embodiment, and in some embodiments, the steps may be performed simultaneously.

S1, providing a circuit board 11. The circuit board 11 includes a substrate layer 111 and a circuit layer 112. The circuit layer 112 is attached to one side surface of the substrate layer 111, and another side surface of the substrate layer 111 is a light-emitting surface 13. A through hole 113 is formed in the circuit board 11.

S2, providing a light-emitting device 12. The light-emitting device 12 includes a fixing portion 21 and an LED light-emitting unit 122. The LED light-emitting unit 122 is fixed on the fixing portion 21.

S3, disposing the light-emitting device 12 corresponding to the through hole 113.

S4, fixing the fixing portion 21 on a side of the circuit layer 112, such that the LED light-emitting unit 122 faces the light-emitting surface 13 through the through hole 113.

The light generated by the LED light-emitting unit 122 passes through the through hole 113 and is emitted from a side of the substrate layer 111 away from the circuit layer 112, such that the side of the substrate layer 111 away from the circuit layer 112 forms the light-emitting surface 13.

A material of the circuit layer 112 may be copper. The circuit layer 112 may be formed by a process of: covering the substrate layer 111 with a copper layer, then etching the copper layer, and finally forming the circuit layer 112. The circuit layer 112 is used for fixing a component 14. The component 14 may be a resistor, a capacitor, an integrated circuit (ICs), or ajumper wire. The circuit layer 112 may supply power or provide electrical signals to the component 14 electrically connected thereto. The substrate layer 111 may be an aluminum substrate, an FR4 substrate, or a BT substrate.

The LED light-emitting unit 122 is electrically connected to the circuit layer 112, and a power source supplies power to the LED light-emitting unit 122 through the circuit layer 112. The light generated by the LED light-emitting unit 122 passes through the through hole 113 and is emitted from the side of the substrate layer 111 away from the circuit layer 112, such that the side of the substrate layer 111 away from the circuit layer 112 forms the light-emitting surface 13.

It should be understood that in the light-emitting plate 10 prepared by the above-described method, the light-emitting surface 13 and the component 14 are formed on opposite sides of the substrate layer 111 of the circuit board 11, thereby completely eliminating the impact of the component 14 on the light-mixing effect, eliminating the steps of applying white adhesive and attaching reflective paper on the component 14, thereby improving the luminous uniformity of the light-emitting plate, and increasing production efficiency, and reducing costs.

In some embodiments, referring to FIG. 10, FIG. 10 is a schematic flowchart of a second method for preparing a light-emitting plate according to an embodiment of the present application. In the above step of providing a circuit board 11, the method for preparing the light-emitting plate 10 includes: S101, providing a substrate layer 111; S102, forming a circuit layer 112 on the substrate layer 111; S103, forming a through hole 113 in the substrate layer 111 and the circuit layer 112, where the through hole 113 penetrates the substrate layer 111 and the circuit layer 112.

Referring to FIG. 11, FIG. 11 is a schematic flowchart of a third method for preparing a light-emitting plate according to an embodiment of the present application. After the step of forming the circuit layer 112 on the substrate layer 111, the method for preparing the light-emitting plate 10 further includes: S104, forming a white ink layer 114 on a side of the substrate layer 111 away from the circuit layer 112. The step of forming the through hole 113 in the substrate layer 111 and the circuit layer 112 includes: S105, forming the through hole 113 in the substrate layer 111, the circuit layer 112, and the white ink layer 114, where the through hole 113 sequentially penetrate the circuit layer 112, the substrate layer 111, and the white ink layer 114.

To improve the light reflectivity of the circuit board 11, the circuit board 11 further includes a white ink layer 114. The white ink layer 114 is disposed on a side of the substrate layer 111 away from the circuit layer 112. Thus, the circuit board 11 includes the circuit layer 112, the substrate layer 111, and the white ink layer 114 stacked in sequence. As described above, a through hole 113 is formed in the circuit board 11, and the through hole 113 sequentially penetrate the circuit layer 112, the substrate layer 111, and the white ink layer 114. When light generated by the LED light-emitting unit 122 passes through the through hole 113 and is emitted from the side of the substrate layer 111 away from the circuit layer 112, a side surface of the white ink layer 114 away from the circuit layer 112 forms the light-emitting surface 13. Light emitted on the white ink layer 114 may be reflected and re-emitted to avoid being absorbed by the substrate layer 111, which is beneficial to increase the light intensity of the light-emitting surface.

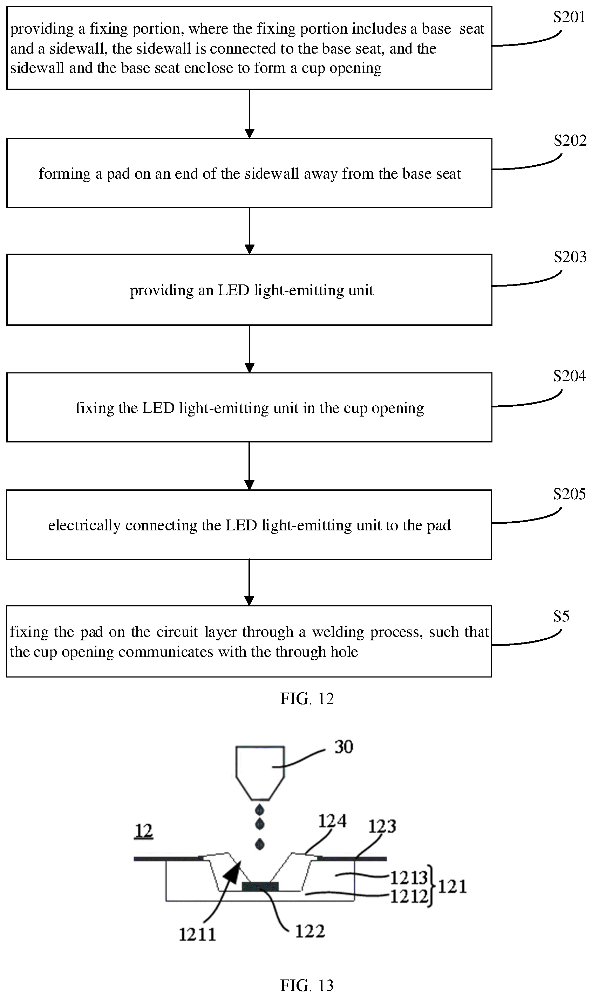

In some embodiments, referring to FIG. 12, FIG. 12 is a schematic flowchart of a fourth method for preparing a light-emitting plate according to an embodiment of the present application. The step of providing a light-emitting device 12 includes: S201, providing a fixing portion 21, where the fixing portion 21 includes a base seat 1212 and a sidewall 1213, the sidewall 1213 is connected to the base seat 1212, and the sidewall 1213 and the base seat 1212 enclose to form a cup opening 1211; S202, forming a pad 123 on an end of the sidewall 1213 away from the base seat 1212; S203, providing an LED light-emitting unit 122; S204, fixing the LED light-emitting unit 122 in the cup opening 1211; and S205, electrically connecting the LED light-emitting unit 122 to the pad 123.

The steps of fixing the fixing portion 21 on a side of the circuit layer 112 away from the substrate layer 111 and electrically connecting the LED light-emitting unit 122 to the circuit layer 112 include: S5, fixing the pad 123 on the circuit layer 112 through a welding process, such that the cup opening 1211 communicates with the through hole 113.

It should be noted that the fixing portion 21 may be a base on which a recess is formed, and the recess serves as the cup opening 1211. In this case, the LED light-emitting unit 122 being disposed at the center of the cup opening 1211 means that the LED light-emitting unit is disposed at the center of the base, at the deepest point of the recess. The cup opening 1211 communicates with the through hole 113. That is, the fixing portion 21 includes a base seat 1212 and a sidewall 1213. The sidewall 1213 is connected to the base seat 1212, and the sidewall 1213 and the base seat 1212 enclose to form the cup opening 1211.

The light-emitting device 12 further includes a pad 123. The pad 123 is disposed on the fixing portion 21. The pad 123 may be disposed on an end of the sidewall 1213 of the fixing portion 21 away from the base seat 1212. The fixing portion 21 is welded to the circuit layer 112 via the pad 123, that is, the pad 123 is connected to the circuit layer 112 and the fixing portion 21, respectively. Since the material of the pad 123 is metal, when the pad 123 is connected to the circuit layer 112, the pad 123 further functions as a conductor. The LED light-emitting unit 122 is also electrically connected to the pad 123, so that the LED light-emitting unit 122 is indirectly electrically connected to the circuit layer 112, thereby reducing jumper wires, saving costs, and saving space.

Therefore, in embodiments of the present application, the pad 123 is connected between the fixing portion 21 and the circuit layer 112, and the pad 123 is also electrically connected to the LED light-emitting unit 122. The pad 123 may not only fix the fixing portion 21 on the circuit layer 112, but also utilize its conductivity to transmit electrical signals from the circuit layer 112 to the LED light-emitting unit 122, so that the LED light-emitting unit 122 may be turned on or turned off.

The light-emitting device 12 further includes a gold wire 124. The gold wire 124 is electrically connected to the LED light-emitting unit 122 and the pad 123. The gold wire 124 has excellent electrical conductivity and is configured to transmit electrical signals to the LED light-emitting unit 122. Specifically, the step of electrically connecting the LED light-emitting unit 122 to the pad 123 includes: providing a gold wire 124, and connecting the two ends of the gold wire 124 to the pad 123 and the LED light-emitting unit 122, respectively.

It should be noted that since the cup opening 1211 is provided to accommodate the LED light-emitting unit 122, it may accommodate at least a portion of the gold wire 124, such that the gold wire 124 does not occupy additional space. The LED light-emitting unit 122 has a positive electrode and a negative electrode. Correspondingly, there are also two gold wires 124 and two pads 123, which are denoted as a first gold wire 124, a second gold wire 124, a first pad 123, and a second pad 123, respectively. The first pad 123 and the second pad 123 are spaced apart on the fixing portion 21. One end of the first gold wire 124 is electrically connected to the first pad 123, and another end thereof is electrically connected to the positive electrode of the LED light-emitting unit 122. The first pad 123 is electrically connected to the circuit layer 112. One end of the second gold wire 124 is electrically connected to the second pad 123, and another end thereof is electrically connected to the negative electrode of the LED light-emitting unit 122. The second pad 123 is electrically connected to the circuit layer 112.

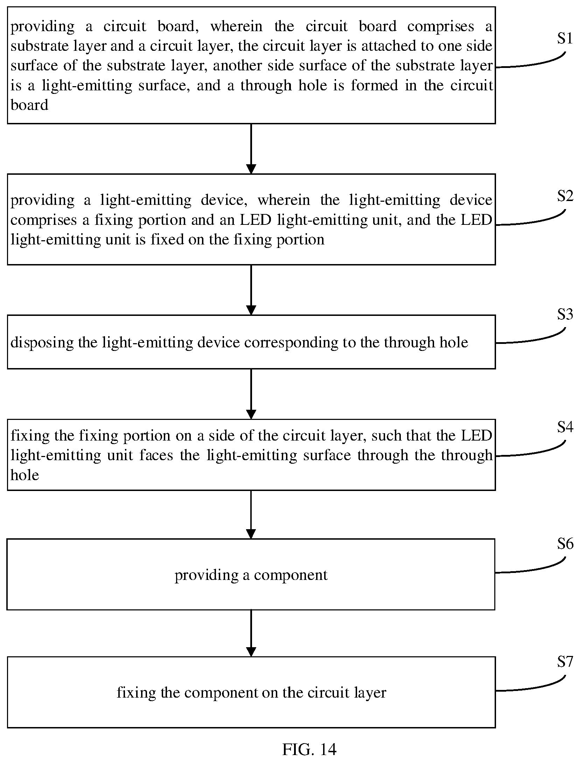

Referring to FIG. 14, FIG. 14 is a schematic flowchart of a fifth method for preparing a light-emitting plate according to an embodiment of the present application. Before the step of fixing the pad 123 on the circuit layer 112 through a welding process, the method for preparing the light-emitting plate 10 further includes: adsorbing a side of the base seat 1212 of the fixing portion 21 away from the cup opening 1211 by an adsorption device 30; and moving the light-emitting device 12 onto the circuit board 11, such that the through hole 113 communicates with the cup opening 1211.

It should be noted that the adsorption device 30 adsorbs the fixing portion 21 by means of vacuum adsorption, so that the light-emitting device 12 is moved to the circuit board 11, facilitating the subsequent welding process. By using the adsorption device 30 to transfer the light-emitting device 12, manual labor may be effectively replaced, thereby improving efficiency.

Referring to FIG. 13, FIG. 13 is a schematic diagram of a second process for a light-emitting plate according to an embodiment of the present application. After electrically connecting the LED light-emitting unit 122 to the pad 123, the method for preparing the light-emitting plate 10 further includes: applying a resin mixture on the LED light-emitting unit 122 using a dispensing head 40, where the resin mixture includes a resin material and a white phosphor powder 1252, and the white phosphor powder 1252 is dispersed in the resin mixture; and curing the resin mixture to form a lens 125, where the lens 125 covers the LED light-emitting unit 122. The lens 125 is configured to expand a light-emitting angle of the LED light-emitting unit 122.

Since the lens 125 is disposed within the cup opening 1211 of the fixing portion 21, when the resin mixture is applied on the LED light-emitting unit 122, it may be directly filled into the cup opening 1211 and may further cover a portion of the pad 123. The lens 125 formed after the resin mixture is cured may not only expand the light-emitting angle of the LED light-emitting unit 122, but also encapsulate the LED light-emitting unit 122, which may protect the LED light-emitting unit 122 and is beneficial to improve the stability of the light-emitting unit.

In some embodiments, referring to FIG. 14, FIG. 14 is a schematic flowchart of a fifth method for preparing a light-emitting plate according to an embodiment of the present application. After the step of connecting the fixing portion 21 to the circuit layer 112, the method for preparing the light-emitting plate 10 further includes: S6, providing a component 14; and S7, fixing the component 14 on the circuit layer 112.

The component 14 may be welded to a side of the circuit layer 112 away from the substrate layer 111. The component 14 may be spaced apart from the light-emitting device 12. Further, on the circuit layer 112, the component 14 may be spaced apart from the fixing portion 21.

It can be understood that the component 14 are welded to the side of the circuit layer 112 away from the substrate layer 111, such that the light-emitting surface 13 of the light-emitting plate 10 and the components 14 are formed on opposite sides of the substrate layer 111 of the circuit board 11, so that the impact of the component 14 on the light-mixing effect is completely eliminated, and there is no need to apply white glue and attach reflective paper on the component 14, thereby improving the luminous uniformity of the light-emitting substrate.

In some scenarios for preparing the light-emitting plate 10, firstly, a circuit board 11 is provided. The circuit board 11 includes a substrate layer 111 and a circuit layer 112, where the circuit layer 112 is attached to the substrate layer 111. A through hole 113 is formed in the circuit board 11, and the through hole 113 penetrates the substrate layer 111 and the circuit layer 112. Then, a light-emitting device 12 is provided. The light-emitting device 12 includes a fixing portion 21 and an LED light-emitting unit 122, and the LED light-emitting unit 122 is fixed on the fixing portion 21. Next, the fixing portion 21 is fixed on a side of the circuit layer 112 away from the substrate layer 111. Finally, the LED light-emitting unit 122 is electrically connected to the circuit layer 112. Light generated by the LED light-emitting unit 122 passes through the through hole 113 and is emitted from a side of the substrate layer 111 away from the circuit layer 112, such that a side surface of the substrate layer 111 away from the circuit layer 112 forms a light-emitting surface 13.

In other scenarios for preparing the light-emitting plate 10, in a first step, a white ink layer 114 is coated on one side of the substrate layer 111 to create a reflective surface, and a circuit layer 112 is prepared on another side of the substrate layer 111 to create a welding surface. A through hole 113 is drilled at a specific position. The material of the substrate layer 111 may be an aluminum-based, a FR4, or a BT. In a second step, a light-emitting device 12 is designed and prepared. A front-mounted LED light-emitting unit 122 is fixed inside the fixing portion 21, and the LED light-emitting unit 122 and the fixing portion 21 are electrically connected via a gold wire 124. In a third step, a resin mixture is applied over the fixing portion 21 and cured to form a resin polymer 1251. The resin polymer 1251 encapsulates the LED light-emitting unit 122 to form a lens 125. The lens 125 may protect the LED chip and expand the light-emitting angle of the LED. The resin mixture may be a thermosetting resin or a photocurable resin. The resin mixture may be mixed with a white phosphor powder 1252 in a mass ratio of 10:1 to 20:1, thereby converting blue light emitted by the LED light-emitting unit 122 into white light. In a fourth step, solder paste is printed on a side of the circuit board 11 where the circuit layer 112 is disposed, and the light-emitting device 12 and a component 14 (such as a resistor, a capacitor, an integrated circuit (IC), and a jumper) are mounted on the surface of the circuit layer 112, where the cup opening 1211 of the light-emitting device 12 faces downward and is aligned with the through hole 113 provided on the circuit board 11.

An embodiment of the present application further provides a backlight module. The backlight module includes the above-mentioned light-emitting plate 10 or a light-emitting plate 10 prepared by the method for preparing the light-emitting plate 10. The backlight module may further include a light guide plate, a lower diffuser sheet, a prism sheet, and an upper diffuser sheet. Light generated by the light-emitting plate 10 is adjusted by passing sequentially through the light guide plate, the lower diffuser sheet, the prism sheet, and the upper diffuser sheet, and ultimately forming uniform outgoing light with a consistent direction.

An embodiment of the present application further provides a display apparatus. The display apparatus includes the above-mentioned backlight module and a liquid crystal module. Light generated by the backlight module is emitted to the liquid crystal module, so that the liquid crystal module may display a picture. The display apparatus may be a television, a mobile phone, a computer, a tablet computer, or a wearable device.

In the light-emitting plate 10 and preparation method therefor, the backlight module, and the display apparatus provided by the embodiments of the present application, the light-emitting plate 10 includes a circuit board 11 and a light-emitting device 12. Specifically, the circuit board 11 includes a substrate layer 111 and a circuit layer 112. The circuit layer 112 is attached to one side surface of the substrate layer 111, and another side surface of the substrate layer 111 is a light-emitting surface 13. A through hole 113 is formed in the circuit board 11. The A circuit layer 112 is configured to weld a component 14. The light-emitting device 12 includes a fixing portion 21 and an LED light-emitting unit 122. The light-emitting device 12 is disposed corresponding to the through hole 113. The fixing portion 21 is disposed on a side of the circuit layer 112, and the LED light-emitting unit 122 faces the light-emitting surface 13 through the through hole 113. That is, light generated by the LED light-emitting unit 122 passes through the through hole 113 and is emitted from a side of the substrate layer 111 away from the circuit layer 112, such that the side surface of the substrate layer 111 away from the circuit layer 112 forms the light-emitting surface 13. It can be understood that the light-emitting surface 13 of the light-emitting plate 10 and the component 14 are formed on opposite sides of the substrate layer 111 of the circuit board 11, so that the impact of the component 14 on the light-mixing effect is completely eliminated, and there is no need to apply white glue and attach reflective paper on the component 14, thereby improving the luminous uniformity of the light-emitting substrate.

In the foregoing embodiments, the descriptions of the various embodiments each have their own emphasis. For parts that are not described in detail in a certain embodiment, reference may be made to the relevant descriptions of other embodiments.

In the description of the present application, the terms "first" and "second" are used for descriptive purposes only and maynot be understood as indicating or implying relative importance or implicitly indicating the number of technical features indicated. Thus, a feature defined by "first" or "second" may explicitly or implicitly include one or more of that feature.

The light-emitting plate and preparation method therefor, the backlight module, and the display apparatus provided by the embodiments of the present application have been described in detail above. Herein, specific examples are used to explain the principles and implementation methods of the present application. The descriptions of the above embodiments are only for helping to understand the present application. Furthermore, for those skilled in the art, there will be changes in the specific implementation methods and application scope based on the ideas of the present application. In summary, the content of this specification should not be construed as a limitation on the present application.

## Claims

1. A light-emitting plate, comprising:
a circuit board, wherein the circuit board comprises a substrate layer and a circuit layer, the circuit layer is attached to one side surface of the substrate layer, another side surface of the substrate layer is a light-emitting surface, and a through hole is formed in the circuit board; and
a light-emitting device, wherein the light-emitting device comprises a fixing portion and an LED light-emitting unit, the LED light-emitting unit is fixed on the fixing portion, the light-emitting device is disposed corresponding to the through hole, the fixing portion is disposed on a side of the circuit layer, and the LED light-emitting unit faces the light-emitting surface through the through hole.

2. The light-emitting plate according to claim 1, wherein the light-emitting device further comprises a pad, the pad is disposed on the fixing portion, the pad is connected to the circuit layer and the fixing portion respectively, the pad is further electrically connected to the LED light-emitting unit, and the pad is configured for fixing the fixing portion on the circuit layer; and
the fixing portion has a cup opening, the LED light-emitting unit is disposed in the cup opening, and the cup opening communicates with the through hole.

3. The light-emitting plate according to claim 2, wherein the fixing portion comprises a base seat and a sidewall, the sidewall is connected to the base seat, the sidewall and the base seat enclose to form the cup opening, and the pad is disposed on an end of the sidewall away from the base seat.

4. The light-emitting plate according to claim 2, wherein the light-emitting device further comprises a gold wire, and the gold wire is electrically connected to the LED light-emitting unit and the pad respectively.

5. The light-emitting plate according to claim 1, wherein the circuit board further comprises a white ink layer, the white ink layer is disposed on a side of the substrate layer away from the circuit layer, the through hole sequentially penetrate the circuit layer, the substrate layer, and the white ink layer, and the white ink layer is configured for reflecting light generated by the LED light-emitting unit.

6. The light-emitting plate according to claim 1, wherein the light-emitting device further comprises a lens, the lens covers the LED light-emitting unit, and the lens is configured for expanding a light-emitting angle of the LED light-emitting unit.

7. The light-emitting plate according to claim 6, wherein the LED light-emitting unit is a blue light-emitting unit, a material of the lens comprises a resin polymer and a white phosphor powder, the white phosphor powder is dispersed in the resin polymer, and the white phosphor powder is configured for converting blue light emitted by the LED light-emitting unit into white light.

8. The light-emitting plate according to claim 7, wherein the resin polymer is a thermosetting resin or a photocurable resin.

9. The light-emitting plate according to claim 7, wherein a composition of the material of the lens, by mass percentage, comprise: 80%-90% of the resin polymer, and 10%-20% of the white phosphor powder.

10. The light-emitting plate according to claim 1, wherein the substrate layer is an aluminum substrate, an FR4 substrate, or a BT substrate.

11. A method for preparing a light-emitting plate, comprising:
providing a circuit board, wherein the circuit board comprises a substrate layer and a circuit layer, the circuit layer is attached to one side surface of the substrate layer, another side surface of the substrate layer is a light-emitting surface, and a through hole is formed in the circuit board;
providing a light-emitting device, wherein the light-emitting device comprises a fixing portion and an LED light-emitting unit, and the LED light-emitting unit is fixed on the fixing portion;
disposing the light-emitting device corresponding to the through hole; and
fixing the fixing portion on a side of the circuit layer, and the LED light-emitting unit faces the light-emitting surface through the through hole.

12. The method for preparing a light-emitting plate according to claim 11, wherein providing a circuit board comprises:
providing a substrate layer;
forming a circuit layer on the substrate layer; and
forming a through hole in the substrate layer and the circuit layer, wherein the through hole penetrates the substrate layer and the circuit layer.

13. The method for preparing a light-emitting plate according to claim 12, wherein after forming the circuit layer on the substrate layer, the method further comprises:
forming a white ink layer on a side of the substrate layer away from the circuit layer;
wherein forming a through hole in the substrate layer and the circuit layer comprises: forming a through hole in the substrate layer, the circuit layer, and the white ink layer, and the through hole sequentially penetrate the circuit layer, the substrate layer, and the white ink layer.

14. The method for preparing a light-emitting plate according to claim 11, wherein providing a light-emitting device comprises:
providing a fixing portion, wherein the fixing portion comprises a base seat and a sidewall, the sidewall is connected to the base seat, and the sidewall and the base seat enclose to form a cup opening;
forming a pad on an end of the sidewall away from the base seat;
providing an LED light-emitting unit;
fixing the LED light-emitting unit in the cup opening; and
electrically connecting the LED light-emitting unit to the pad;
wherein fixing the fixing portion on a side of the circuit layer away from the substrate layer and electrically connecting the LED light-emitting unit to the circuit layer comprises: fixing the pad on the circuit layer through a welding process to have the cup opening communicates with the through hole.

15. The method for preparing a light-emitting plate according to claim 14, wherein before fixing the pad on the circuit layer through a welding process, the method further comprises:
adsorbing a side of the base seat of the fixing portion away from the cup opening by an adsorption device; and
moving the light-emitting device onto the circuit board to have the through hole communicates with the cup opening.

16. The method for preparing a light-emitting plate according to claim 14, wherein after electrically connecting the LED light-emitting unit to the pad, the method further comprises:
applying a resin mixture on the LED light-emitting unit using a dispensing head, wherein the resin mixture comprises a resin material and a white phosphor powder, and the white phosphor powder is dispersed in the resin mixture; and
curing the resin mixture to form a lens, wherein the lens covers the LED light-emitting unit.

17. The method for preparing a light-emitting plate according to claim 11, wherein after connecting the fixing portion to the circuit layer, the method further comprises:
providing a component; and
welding the component to a side of the circuit layer away from the substrate layer.

18. A backlight module, comprising a light-emitting plate, wherein the light-emitting plate comprises:
a circuit board, wherein the circuit board comprises a substrate layer and a circuit layer, the circuit layer is attached to one side surface of the substrate layer, another side surface of the substrate layer is a light-emitting surface, and a through hole is formed in the circuit board; and
a light-emitting device, wherein the light-emitting device comprises a fixing portion and an LED light-emitting unit, the LED light-emitting unit is fixed on the fixing portion, the light-emitting device is disposed corresponding to the through hole, the fixing portion is disposed on a side of the circuit layer, and the LED light-emitting unit faces the light-emitting surface through the through hole.

19. A backlight module, comprising a light-emitting plate prepared by a method for preparing a light-emitting plate, wherein the method for preparing the light-emitting plate comprises:
providing a circuit board, wherein the circuit board comprises a substrate layer and a circuit layer, the circuit layer is attached to one side surface of the substrate layer, another side surface of the substrate layer is a light-emitting surface, and a through hole is formed in the circuit board;
providing a light-emitting device, wherein the light-emitting device comprises a fixing portion and an LED light-emitting unit, and the LED light-emitting unit is fixed on the fixing portion;
disposing the light-emitting device corresponding to the through hole; and
fixing the fixing portion on a side of the circuit layer, and the LED light-emitting unit faces the light-emitting surface through the through hole.

20. A display apparatus, comprising a backlight module, wherein the backlight module comprises a light-emitting plate, and the light-emitting plate comprises:
a circuit board, wherein the circuit board comprises a substrate layer and a circuit layer, the circuit layer is attached to one side surface of the substrate layer, another side surface of the substrate layer is a light-emitting surface, and a through hole is formed in the circuit board; and
a light-emitting device, wherein the light-emitting device comprises a fixing portion and an LED light-emitting unit, the LED light-emitting unit is fixed on the fixing portion, the light-emitting device is disposed corresponding to the through hole, the fixing portion is disposed on a side of the circuit layer, and the LED light-emitting unit faces the light-emitting surface through the through hole.
